# EUROPEAN PATENT APPLICATION

(11) **EP 0 560 287 A1**
(43) Date of publication of application: **15.09.1993**
(21) Application number: 93103766.7
(22) Date of filing: 09.03.1993
(51) Int. Cl.: C23C 16/26, B23B 27/20

(54) **Diamond cutting tool and method of manufacturing the same**

(30) Priority: 10.03.1992 JP 51823/92
(71) Applicant: SUMITOMO ELECTRIC INDUSTRIES, LIMITED, Osaka 541 (JP)
(72) Inventor: Tanabe, Keiichiro, c/o Itami Works of, Itami-shi, Hyogo (JP); Ikegaya, Akihiko, c/o Itami Works of, Itami-shi, Hyogo (JP); Takahashi, Toshiya, c/o Itami Works of, Itami-shi, Hyogo (JP); Fujimori, Naoji, c/o Itami Works of, Itami-shi, Hyogo (JP)
(74) Representative: Herrmann-Trentepohl, Werner, Dipl.-Ing.

(57) **Abstract**

Provided herein is a diamond cutting tool having a rake face (5) of a cutting edge member (2) consisting essentially of a (111) plane of diamond. The cutting edge member (2) of diamond is vapor-deposited by CVD or the like on an independently prepared base material. In this vapor deposition, the diamond is so deposited that a (111) crystal plane is substantially parallel to the base material surface. The as-formed diamond material is separated from the base material and worked into a desired shape, to be bonded to a tool base (1) through a metallization layer (4) and a brazing layer (3) as the cutting edge member (2). The brazing is so performed that the (111) plane defines the rake face (5). The tool having such a rake face (5) consisting essentially of the (111) plane having high hardness is excellent in wear resistance.

## Description

### BACKGROUND OF THE INVENTION

### Field of the Invention

The present invention relates to a diamond cutting tool, and more particularly, it relates to a cutting tool which has a cutting edge of diamond formed by vapor deposition and is excellent in wear resistance, heat resistance and chipping resistance, and a method of manufacturing the same.

### Description of the Background Art

Diamond, which is excellent in hardness and thermal conductivity, is particularly useful as a material for forming a tool for cutting an uncuttable material.

Such diamond materials applicable to tools are classified into single-crystalline and polycrystalline diamond materials. However, single-crystalline diamond is extremely high-priced, hard to work and easy to cleave, although the same is an excellent material in consideration of its physical characteristics.

On the other hand, polycrystalline diamond materials which are applicable to tools can be roughly classified into two types. The first one is sintered diamond, which is obtained by sintering fine diamond powder and an iron family metal such as Co under diamond-stable very high pressure and temperature conditions. Such a sintering technique is described in Japanese Patent Publication No. 52-12126 (1977), for example. It is known that, among commercially available sintered diamond materials, particularly that of not more than several 10 µm in grain size has excellent wear resistance with no cleavage such as that caused in the aforementioned single-crystalline diamond. However, sintered diamond contains several to several 10 % of a binder, and hence a cutting edge of such sintered diamond may be chipped due to fall of diamond particles forming a sintered body. Since such fall is remarkably caused as a wedge angle of the cutting edge is reduced, it is difficult to maintain a sharp cutting edge of sintered diamond for a long time. Further, the sintered diamond is inferior in heat resistance to the single-crystalline diamond and easily worn in cutting, due to the binder contained therein.

On the other hand, vapor-deposited diamond, which is the second type of polycrystalline diamond applicable to a cutting tool, is superior in heat resistance and wear resistance to the sintered diamond and hardly causes chipping since the same is dense and consists essentially of only diamond. Such vapor-deposited diamond is generally prepared by chemical vapor deposition (CVD) of decomposing and exciting a raw material which is mainly composed of hydrocarbon such as methane and hydrogen under a low pressure.

As to a cutting tool employing such vapor-deposited diamond, there has been developed a diamond-coated tool comprising a tool substrate directly coated with diamond, for example. In such a diamond-coated tool, adhesion between the tool substrate and a diamond thin film coating the same is important, because the diamond thin film may be separated during cutting work in a tool of cemented carbide coated with such a diamond thin film, for example.

There has also been developed a diamond cutting tool comprising a tool substrate and a vapor-deposited diamond containing member brazed thereto. For example, each of Japanese Patent Laying-Open Nos. 1-153228 (1989) and 1-210201 (1989) discloses a technique of directly brazing a base material which is coated with vapor-deposited diamond to a tool substrate of cemented carbide to prepare a cutting tool. In order to apply such a tool to practical use, however, it is necessary to polish the base material or the diamond film on a rake face side. In such vapor-deposited diamond, the diamond surface is so coarse immediately after vapor deposition that it is necessary to polish this surface to apply the same to a rake face of an cutting edge. In order to facilitate such finishing, diamond which is vapor-deposited on a base material is generally so formed that a (100) plane and/or a (110) plane is oriented in parallel with the base material surface. In general, therefore, a rake face of an insert is formed by the (100) or (110) plane. However, such a (100) or (110) plane cannot be regarded as optimum in consideration of wear resistance of the cutting tool, although the same is preferable in view of the aforementioned polishing.

### SUMMARY OF THE INVENTION

An object of the present invention is to provide a diamond cutting tool which is superior in wear resistance to the prior art.

The diamond cutting tool according to the present invention is characterized in that, in a cutting tool having a cutting edge which consists essentially of a vapor-deposited diamond material, a principal diamond crystal plane forming a rake face of the cutting edge is the (111) plane. In such a cutting edge, the (111) plane is preferably oriented as a principal plane, as parallel as possible to the rake face, up to a depth of at least 20 µm from the rake face.

In the rake face and its proximity (e.g., up to a depth of about 20 µm from the rake face), it is preferable to suppress mixing of crystal planes but the (111) plane to the minimum. Assuming that the (111) plane is 100 in intensity in X-ray analysis, (220), (311), (400) and (331) planes are preferably not more than about 80, more preferably not more than about 10 in intensity respectively. In the cutting edge, further, it is more preferable that the (111) plane has an FWHM (full width at half maximum intensity) value of less than about 20° in a rocking curve obtained by introduction of X rays through the rake face, as an index showing the orientation property of the (111) plane. In addition, the (220) plane preferably has an FWHM value of at least about 20° in such a rocking curve.

In the cutting tool according to the present invention, further, the rake face preferably has surface roughness Rₘₐₓ of not more than about 0.5 µm.

The inventive diamond cutting tool can be manufactured by either one of the following two methods:
A manufacturing method according to the present invention includes a step of preparing a base material having a mirror-finished surface for depositing diamond thereon, a step of depositing diamond on the surface by vapor deposition so that its (111) plane is oriented substantially in parallel with the surface, a step of separating or removing the base material on which the diamond is deposited to obtain a diamond material serving as a cutting edge member, and a step of brazing the diamond material to a tool substrate so that a surface of the diamond material having been in contact with the base material defines a rake face.

Another manufacturing method according to the present invention includes a step of preparing a base material having a surface for depositing diamond thereon, a step of depositing a first diamond layer on the surface by vapor deposition so that its (111) plane is oriented substantially in parallel with the surface, a step of then depositing a second diamond layer on the first diamond layer so that a crystal plane being lower in hardness than the (111) plane is oriented and thereafter obtaining a diamond material for serving as a cutting edge member, a step of brazing the diamond material to a tool substrate so that a rake face of a cutting edge is defined by the second diamond layer side, and a step of removing the second diamond layer by mirror polishing thereby exposing the (111) plane.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a sectional view schematically illustrating a diamond cutting tool prepared in Example 1; and
Figs. 2A and 2B are sectional views schematically showing steps of manufacturing a diamond cutting tool in Example 3.

### DETAILED DESCRIPTION OF THE INVENTION

According to the present invention, various vapor deposition methods are applicable to formation of diamond by vapor deposition. For example, a CVD method of decomposing/exciting a raw material gas by thermionic emission or plasma discharge, another CVD method employing a combustion flame and the like are effective. The raw material gas can be prepared from a gas which is mainly composed of a mixture of hydrocarbon such as methane, ethane or propane, alcohol such as methanol or ethanol or an organic carbon compound such as ester and hydrogen. The raw material gas may additionally contain inert gas such as argon, oxygen, carbon monoxide, water and the like in a range not inhibiting deposition of diamond and characteristics thereof.

According to the present invention, the (111) plane can be generally formed by reducing carbon concentration with respect to gaseous hydrogen, for example, in the aforementioned CVD. A base material for vapor deposition is preferably made of Si or Mo, for example. Such a base material can be separated or removed from the diamond by mechanical working or dissolution or separation by chemical processing.

In the former one of the aforementioned manufacturing methods, the surface of the base material to be provided with diamond is preferably mirror-finished to be not more than about 1 µm, more preferably not more than about 0.2 µm in surface roughness Rₘₐₓ. It is possible to deposit the diamond in a thickness of about 20 to 3000 µm, for example, by CVD or the like on such a mirror-finished base material surface. After this base material is separated or removed, the remaining diamond may be directly subjected to a next step, or worked into proper dimensions by cutting, for example. The diamond material obtained by separating or removing the base material is brazed to a tool substrate. In such brazing, a diamond surface which has been in contact with the base material, i.e., a crystal growth start surface, is rendered to define a rake face of a cutting edge. In general, therefore, a surface opposite to this surface, i.e., a crystal growth end surface, is employed for brazing. This surface to be brazed is preferably provided with a metallization layer consisting of a metal included in the group IVa, IVb, Va, Vb, VIa, VIb, VIIa or VIIb of the periodic table or a compound thereof in advance of the brazing. The brazing can be effectively performed through this metallization layer.

According to this method, diamond is first deposited on a mirror-finished base material surface by vapor deposition. In a diamond material obtained by separating or removing the base material after deposition of the diamond, therefore, a surface which has been in contact with the base material is already mirror-finished. This surface may not be polished, or is sufficiently subjected to simple polishing. Further, the vapor deposition is so performed that the (111) plane is oriented in parallel with the base material surface, whereby the surface of the diamond material which has been in contact with the base material is substantially occupied by the (111) plane. When the diamond material is so brazed to a tool substrate that the surface which has been in contact with the base material defines a rake face, therefore, it is possible to easily obtain a tool which is superior in wear resistance to the prior art.

If another surface, which has not been in contact with a base material, is adapted to define a rake face in such a diamond material prepared by vapor deposition, this leads to the following problem: A surface such as a growth end surface in vapor deposition, for example, can also be substantially occupied by the (111) plane. However, the growth end surface is so coarse that the same must be polished for defining a rake face, and it is extremely difficult to polish this surface due to high hardness of the (111) plane. Further, the growth end surface has a relatively large diamond crystal grain size. This surface is liable to chip than the growth start surface. When the surface which has been in contact with the base material is employed as a rake face, on the other hand, no chipping is caused and excellent wear resistance is attained since this surface is flat and has a structure of a fine grain size. This surface may not be polished, or is sufficiently subjected to simple working.

In the latter one of the aforementioned manufacturing methods, a second diamond layer having low hardness is deposited on the (111) plane of a diamond layer which is formed in a thickness of about 20 to 3000 µm. A crystal plane which is lower in hardness than the (111) plane can be generally formed by increasing carbon concentration with respect to gaseous hydrogen, for example, in the aforementioned CVD. A (220) plane, for example, is preferably selected as such a crystal plane having low hardness. The diamond layer on which the crystal plane being lower in hardness than the (111) plane is oriented is preferably about 50 µm, more preferably about 10 µm in thickness. In this method, a diamond material for serving as a cutting edge member may be prepared from diamond which is independent of a base material separated or removed therefrom, or from diamond which remains being deposited on such a base material. The as-obtained diamond material may be directly subjected to a next step, or worked into proper dimensions by cutting or the like, for example. The diamond material serving as a cutting edge member is brazed to a tool substrate so that the diamond layer side defines a rake face. In general, therefore, the diamond surface which has been in contact with the base material during the vapor deposition, i.e., the crystal growth start surface, is employed for brazing. The surface to be brazed may be provided with a metallization layer which is similar to that described above in advance of the brazing. The brazing can be effectively performed through this metallization layer. Then, the diamond layer having low hardness is removed by polishing, thereby exposing the (111) plane of the previously formed diamond layer. In this step, a rake face obtained by exposing the (111) plane by mirror polishing preferably has surface roughness Rₘₐₓ of not more than about 0.2 µm, for example. In the rake face obtained after mirror finishing and its proximity (e.g., up to a depth of about 20 µm from the rake face), further, it is preferable to suppress mixing of crystal planes but the (111) plane to the minimum. Assuming that the (111) plane is 100 in intensity in X-ray analysis, for example, (220), (311), (400) and (331) planes are preferably not more than about 80, more preferably not more than about 10 in intensity respectively.

In this manufacturing method, the second diamond layer provided with a crystal plane having low hardness oriented thereon is deposited on the first diamond layer provided with the (111) plane having high hardness oriented thereon. Due to the low hardness, the second diamond layer can be easily mirror-polished. When the diamond material is so brazed that a rake face of a cutting edge is defined by the second diamond layer side and thereafter this diamond layer is removed by mirror polishing to expose the (111) plane, therefore, it is possible to provide a rake face having high flatness, which is substantially formed of the (111) plane.

According to each of the aforementioned two processes, it is possible to provide a diamond cutting tool having a rake face which is flat and consists essentially of the (111) plane. The (111) plane has the highest hardness among the diamond crystal planes. Therefore, a tool having such a hard rake face is superior in wear resistance to the prior art.

### EXAMPLE

### Example 1

An Si base material was prepared and mirror-finished to have surface roughness Rₘₐₓ of not more than about 0.2 µm.

Polycrystalline diamond of about 250 µm in thickness was deposited on the Si mirror surface by well-known thermal filament CVD using a linear tungsten filament of 0.5 mm in diameter and 100 mm in length as a thermionic emission material under the following conditions:
Raw Material Gas (Flow Rate): CH₄/H₂ = 1 %, Total Flow Rate = 1000 cc/min.
Gas Pressure: 80 Torr
Filament Temperature: 2200°C
Filament-to-Substrate Distance: 5 mm
Substrate Temperature: 920°C
Then, the polycrystalline diamond deposited on the Si base material was cut with a laser beam into dimensions and a shape required for a tool, and thereafter the Si base material was dissolved/separated by fluoronitric acid to obtain a cutting edge member of diamond. The as-obtained cutting edge member of diamond was subjected to X-ray analysis of introducing X rays through a diamond surface which had been in contact with the Si base material. As the result, peak intensity ratios I(220)/I(111) and I(400)/I(111) of (220) and (400) planes to the (111) plane were about 0.1 and about 0.02 respectively, and it was recognized that a strong orientation property was obtained as to the (111) plane. In the as-obtained cutting edge member, further, X rays were introduced through the surface which had been in contact with the base material to obtain an FWHM value of the (111) plane, which was parallel to this surface, in a rocking curve. As the result, the (111) plane exhibited an FWHM value of about 8°, while the (220) plane exhibited an FWHM value of about 25° in such a rocking curve.

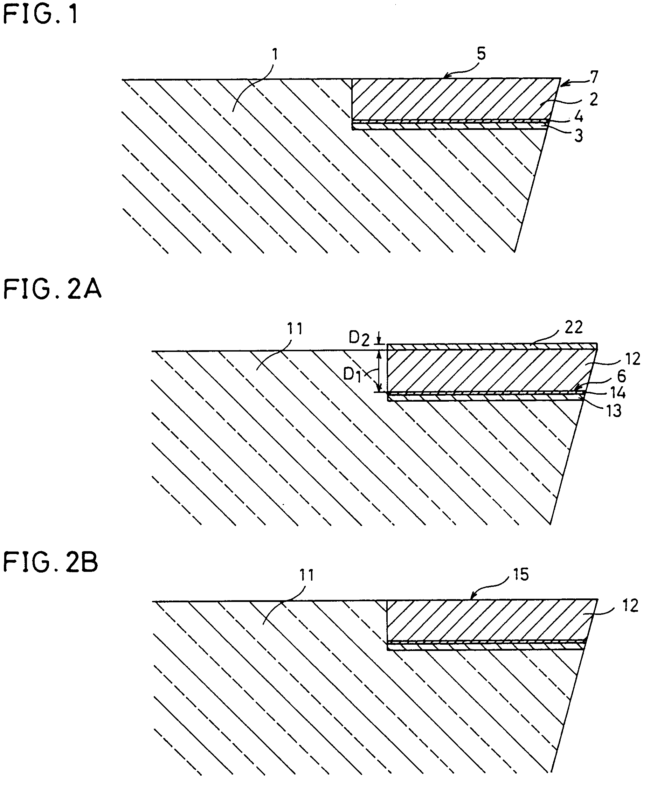

In the as-obtained cutting edge member of diamond, Ti and Ni were successively stacked on the crystal growth end surface in thicknesses of about 1 µm and 2 µm respectively, and thereafter this cutting edge member was vacuum-brazed to a base of cemented carbide (SPG422) with silver solder so that the surface provided with such a metallization layer defined a joint surface. A rake face of this cutting edge member exhibited surface roughness Rₘₐₓ of about 0.2 µm. Fig. 1 shows a principal part of the tool obtained by such brazing. A cutting edge member 2 was fixed to a prescribed region of a base 1 of cemented carbide through a brazing layer 3 and a metallization layer 4. A rake face 5 of the cutting edge member 2 was occupied by the (111) plane. A flank 7 was formed on an end surface of the cutting edge member 2.

### Example 2

An Si base material was mirror-polished to have surface roughness Rₘₐₓ of not more than about 0.2 µm.

Polycrystalline diamond of about 300 µm in thickness was formed on the Si mirror surface by well-known microwave plasma CVD under the following conditions:
Raw Material Gas (Flow Rate): C₂H₂/H₂ = 0.2 %, Total Flow Rate = 600 cc/min.
Gas Pressure: 40 Torr
Microwave Output: 450 W (2.45 GHz)
Substrate Temperature: 900°C
Then, the polycrystalline diamond deposited on the Si base material was cut with a laser beam into dimensions and a shape required for a tool, and thereafter the Si base material was dissolved/removed by fluoronitric acid to obtain a cutting edge member of diamond. The as-obtained cutting edge member of diamond was subjected to X-ray analysis. As the result, peak intensity ratios I(220)/I(111) and I(400)/I(111) were about 0.6 and about 0.08 respectively. Further, the (111) plane exhibited an FWHM value of about 10° in a rocking curve, while the (220) plane exhibited an FWHM value of about 21° in such a rocking curve.

Then, a metallization layer was formed on a crystal growth end surface of the as-obtained cutting edge member similarly to Example 1, and thereafter this cutting edge member was brazed to a base of cemented carbide (SPG422) by silver solder. After this brazing, a surface of the cutting edge member of diamond which had been in contact with the base material was lightly mirror-finished to form a rake face. This rake face exhibited surface roughness Rₘₐₓ of about 0.1 µm.

### Example 3

An Si base material mirror-finished to have surface roughness Rₘₐₓ of not more than about 0.2 µm was employed to form polycrystalline diamond of about 250 µm in thickness on the Si mirror surface by thermal filament CVD using a tungsten filament similarly to Example 1 under the following conditions:
Raw Material Gas (Flow Rate): CH₄/H₂ = 1 %, CO₂/CH₄ = 0.5 %, Total Flow Rate = 600 cc/min.
Gas Pressure: 40 Torr
Filament Temperature: 2150°C
Filament-to-Substrate Distance: 7 mm
Substrate Temperature: 900°C
Then, another thermal filament CVD was performed under the following conditions, to deposit another diamond on the as-formed polycrystalline diamond:
Raw Material Gas (Flow Rate): C₂H₂/H₂ = 3 %, Total Flow Rate = 1000 cc/min.
Gas Pressure: 80 Torr
Filament Temperature: 2150°C
Filament-to-Substrate Distance: 7 mm
Substrate Temperature: 960°C
As the result of X-ray analysis which was made after formation of the first diamond layer, it was recognized that a peak intensity ratio I(220)/I(111) was about 0.8 with strong orientation of the (111) plane parallel to the base material in formation of the first diamond layer. As to the diamond layer which was formed later, on the other hand, it was clarified that a peak intensity ratio I(111)/I(220) was about 0.08 with strong orientation of the (220) plane parallel to the base material surface. Further, the thickness of the diamond layer which was deposited later was about 20 µm.

The diamond material thus formed on the Si base material was cut with a laser beam into dimensions and a shape required for a tool, and thereafter the Si base material was dissolved/removed by fluoronitric acid to obtain a cutting edge member of diamond. In the as-obtained cutting edge member of diamond, Ti and Ni were successively stacked on a surface which had been in contact with the base material in thicknesses of about 1 µm and 2 µm respectively, and thereafter this cutting edge member was vacuum-brazed to a base of cemented carbide (SPG422) with silver solder so that the surface provided with this metallization layer defined a joint surface.

Fig. 2A shows a principal part of a tool in a state immediately after such brazing. A cutting edge member 12 of diamond was fixed to a prescribed region of a base 11 of cemented carbide through a brazing layer 13 and a metallization layer 14.

In this cutting edge member 12, a (111) plane was oriented in parallel with a joint surface 6 in a portion D₁ of a thickness of about 250 µm from the joint surface 6, while a (220) plane was oriented in parallel with the joint surface 6 in another region D₂ of a thickness of about 20 µm deposited thereon. Then, a diamond layer 22 forming the region D₂ shown in Fig. 2A was removed by lapping. It was confirmed by X-ray analysis that thus exposed was a (111) oriented plane with a peak intensity ratio I(220)/((111) of about 0.18. Through this mirror polishing, it was possible to expose the (111) plane of the previously formed diamond layer and to obtain a mirror surface having surface roughness Rₘₐₓ of about 0.1 µm. Fig. 2B shows a principal part of the as-obtained diamond cutting tool. A rake face 15 of the cutting edge member 12 was flattened and mostly formed of the (111) plane.

### Comparative Example

Polycrystalline diamond of about 200 µm in thickness was formed on an Si mirror surface by thermal CVD using an apparatus similar to that employed in Example 1, under the following conditions:
Raw Material Gas (Flow Rate): CH₄/H₂ = 3 %, Total Flow Rate = 1000 cc/min.
Gas Pressure: 80 Torr
Filament Temperature: 2150°C
Filament-to-Substrate Distance: 6 mm
Substrate Temperature: 920°C
Then, the polycrystalline diamond deposited on the Si base material was cut with a laser beam into dimensions and a shape required for a tool, and thereafter the Si base material was dissolved/removed by fluoronitric acid to obtain a cutting edge member of diamond. The as-obtained cutting edge member of diamond was subjected to X-ray analysis, whereby it was recognized that a peak intensity ratio I(111)/I(220) was about 0.1 with strong orientation of the (220) plane. This (220) plane exhibited an FWHM value of about 10° in a rocking curve. The as-obtained cutting edge member was brazed to a base of cemented carbide, similarly to Example 1.

In order to evaluate performance levels of the diamond cutting tools prepared in Examples 1, 2 and 3 and Comparative Example, cutting tests (machining) were made under the following cutting conditions:
Workpiece: A390
Cutting Speed: 800 m/min.
Feed Rate: 0.12 mm/rev.
Depth of Cut: 0.5 mm
Continuous cutting tests were made for about 30 minutes, whereby samples according to Examples 1, 2 and 3 exhibited excellent characteristics with maximum flank wear widths (V_{Bmax})of about 55 µm, 78 µm and 48 µm respectively. On the other hand, a sample according to Comparative Example caused remarkable chipping of at least about 100 µm when the same was subjected to a continuous cutting test for 1 minute.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A diamond cutting tool, comprising:
a cutting edge (2) consisting essentially of a vapor-deposited diamond material,
a principal diamond crystal plane forming a rake face (5) of said cutting edge (2) being a (111) plane.

2. A diamond cutting tool in accordance with claim 1, wherein said (111) plane is oriented substantially in parallel with said rake face (5) as a principal plane up to a depth of at least about 20 µm from said rake face (5) in said cutting edge (2) consisting essentially of said diamond material.

3. A diamond cutting tool in accordance with claim 1, wherein (220), (311), (400) and (331) planes are not more than about 80 in intensity respectively assuming that said (111) plane is 100 in intensity in X-ray analysis.

4. A diamond cutting tool in accordance with claim 3, wherein said (220), (311), (400) and (331) planes are not more than about 10 in intensity respectively.

5. A diamond cutting tool in accordance with claim 1, wherein said (111) plane exhibits an FWHM value of less than about 20° in a rocking curve obtained by introduction of X rays through said rake face (5).

6. A diamond cutting tool in accordance with claim 1, wherein said (220) plane exhibits an FWHM value of at least about 20 ° in a rocking curve obtained by introduction of X rays through said rake face (5).

7. A diamond cutting tool in accordance with claim 1, wherein said rake face (5) has surface roughness Rₘₐₓ of not more than about 0.5 µm.

8. A diamond cutting tool in accordance with claim 1, wherein a member (2) having said cutting edge consisting essentially of a diamond material is bonded to a tool substrate (1).

9. A diamond cutting tool in accordance with claim 8, wherein said member (2) is brazed to said tool substrate (1) through an intermediate layer (4) consisting essentially of one or more materials selected from the group consisting of metals included in the groups IVa, IVb, Va, Vb, VIa, VIb, VIIa and VIIb of the periodic table and compounds thereof.

10. A diamond cutting tool in accordance with claim 8, wherein said tool substrate (1) consists essentially of cemented carbide.

11. A method of manufacturing a diamond cutting tool comprising a cutting edge consisting essentially of a vapor-deposited diamond material, said method comprising:
a step of preparing a base material having a mirror-finished surface for depositing diamond thereon;
a step of depositing diamond on said surface by vapor deposition so that a (111) plane is oriented substantially in parallel with said surface;
a step of separating or removing said material on which said diamond is deposited to obtain a diamond material (2) serving as a cutting edge member; and
a step of brazing said diamond material (2) to a tool substrate (1) so that a surface of said diamond member having been in contact with said base material defines a rake face (5) of said cutting edge.

12. A method in accordance with claim 11, wherein said surface of said base material for depositing diamond thereon is mirror-finished in surface roughness Rₘₐₓ of not more than about 0.2 µm.

13. A method in accordance with claim 11, wherein said diamond is synthesized by CVD in said step of depositing diamond.

14. A method in accordance with claim 11, wherein said diamond material (2) is brazed to said tool substrate through an intermediate layer (4) consisting essentially of one or more materials selected from the group consisting of metals included in the groups IVa, IVb, Va, Vb, VIa, VIb, VIIa and VIIb of the periodic table and compounds thereof.

15. A method of manufacturing a diamond cutting tool comprising a cutting edge consisting essentially of a vapor-deposited diamond material, said method comprising:
a step of preparing a base material having a surface for depositing diamond thereon;
a step of depositing a first diamond layer (12) on said surface by vapor deposition so that a (111) plane is oriented substantially in parallel with said surface;
a step of then depositing a second diamond layer (22) on said first diamond layer (12) so that a crystal plane being lower in hardness than said (111) plane is oriented and thereafter obtaining a diamond material (12), (22) serving as a cutting edge member;
a step of brazing said diamond material (12), (22) to a tool substrate (11) so that a rake face (15) of said cutting edge is defined by said second diamond layer (22) side; and
a step of removing said second diamond layer (22) by mirror polishing thereby exposing said (111) plane.

16. A method in accordance with claim 15, wherein a (220) plane is formed on said second diamond layer (22) as said crystal plane being lower in hardness than said (111) plane.

17. A method in accordance with claim 15, wherein a rake face (15) having surface roughness Rₘₐₓ of not more than about 0.2 µm is formed in said step of exposing said (111) plane by mirror polishing.

18. A method in accordance with claim 15, wherein said first (12) and second diamond layers (22) are continuously formed in CVD.

19. A method in accordance with claim 15, wherein said diamond material (12), (22) is brazed to said tool substrate (11) through an intermediate layer (14) consisting essentially of one or more materials selected from the group consisting of metals included in the groups IVa, IVb, Va, Vb, VIa, VIb, VIIa and VIIb of the periodic table and compounds thereof.
